# EUROPÄISCHE PATENTSCHRIFT

(11) **EP 0 773 600 B1**
(45) Veröffentlichungstag und Bekanntmachung des Hinweises auf die Patenterteilung: **27.02.2002**
(21) Anmeldenummer: 96117465.3
(22) Anmeldetag: 31.10.1996
(51) Int. Cl.: H01R 4/02, H01R 43/02, H01R 12/32

(54) **Elektrische Schaltung**
Electrical circuit
Circuit électrique

(30) Priorität: 10.11.1995 DE 19541976
(43) Veröffentlichungstag der Anmeldung: 14.05.1997
(73) Patentinhaber: E.G.O. ELEKTRO-GERÄTEBAU GmbH, 75038 Oberderdingen (DE)
(72) Erfinder: Diehlmann, Ralf, D-75015 Bretten-Gölshausen (DE); Block, Volker, D-75015 Bretten (DE)
(74) Vertreter: Patentanwälte Ruff, Wilhelm, Beier, Dauster & Partner

(56) Entgegenhaltungen:
- EP-A- 0 421 018
- DE-A- 3 424 387
- US-A- 3 791 028
- US-A- 5 097 100
- PATENT ABSTRACTS OF JAPAN vol. 095, no. 006, 31.Juli 1995 & JP 07 057790 A (TOKAI RIKA CO LTD), 3.März 1995,
- PATENT ABSTRACTS OF JAPAN vol. 003, no. 136 (E-151), 13.November 1979 & JP 54 114790 A (MATSUSHITA ELECTRIC IND CO LTD), 7.September 1979,

## Beschreibung

Die Erfindung betrifft eine elektrische Schaltung nach dem Oberbegriff des Patentanspruches 1. Sie kann insbesondere eine als Baueinheit vormontierte Dickschichtschaltung sein, welche einen formsteifen Träger, an mindestens einer Seite bzw. Oberfläche des Trägers eine lagefest angeordnete elektrische Schaltung und fest mit dieser sowie mit dem Träger verbundene Anschlußleiter enthält, die z.B. als flexible Anschlußdrähte bzw. -kabel frei zugänglich und beliebig biegbar von dem Träger abstehen, um die Schaltung an eine Gerätesteuerung anzuschließen.

Gemäß der DE-A-3 424 387 ist an der zur Schaltungs-Oberfläche parallelen Anschlußfläche des jeweiligen Anschlußteiles ein Anschlußteil des Anschlußleiters mit einer Dickschichtpaste angelötet. Dieser Anschlußteil ist durchgehend einteilig mit einem Längsabschnitt des Anschlußleiters ausgebildet, der weit über den Träger hinaus absteht. Dieser Anschlußteil soll gegenüber der Leiteranordnung einen vielfach größeren Leitungsquerschnitt haben können, der z.B. gegenüber dem maximalen oder minimalen Leitungsquerschnitt der Leiterbahn mindestens zwei-, drei- oder vierhundertfach größer und gegenüber dem entsprechenden Leitungs-querschnitt des Anschlußleiters mindestens zehn- oder fünfzehnfach größer ist und zwar im Bereich der miteinander verbundenen Anschlußflächen.

Für die Leitung höherer Ströme bzw. von Leistungsströmen besteht bei der Anschlußverbindung das Problem, daß sie verhältnismäßig hohe Übergangswiderstände haben können, nur geringe Ströme übertragen können und ihre Festigkeit unter hohen Betriebstemperaturen bis zur gegenseitigen Lösung der Anschlußflächen abfällt, so daß die miniaturisierte Baueinheit bereits nach kurzer Betriebszeit funktionsuntüchtig wird. Wird die Anschlußverbindung durch voneinander abhebbar gegeneinander gepreßte Kontakte gebildet, so können diese Nachteile zwar etwas verringert werden, jedoch ist eine solche Ausbildung sehr kosten- und raumaufwendig.

Aus der EP 0 421 018 A1 ist bekannt, Drahte und/oder Litzen mittels einer Ultraschall-Schweißpresse mit einem metallischen Träger zu verbinden. Eine mechanisch besonders feste sowie elektrisch gut leitfähige Verbindung wird dabei erfindungsgemäß durch ein besonderes Prozeßablaufprofil der Ultraschall-Schweißpressen erzielt.

Der Erfindung liegt die Aufgabe zugrunde, Nachteile bekannter Ausbildungen bzw. der beschriebenen Art zu vermeiden und insbesondere eine Anschlußverbindung zu schaffen, die gegen oberhalb der Schmelzpunkte bzw. Schmelzbereiche von Weichloten liegende Betriebstemperaturen fest ist, die eine hohe Temperaturzyklenfestigkeit hat, eine hohe mechanische Stabilität aufweist, einen niedrigen Übergangswiderstand bildet, die Übertragung hoher Ströme ermöglicht und/oder kostengünstig in der Herstellung von Großserien ist.

Erfindungsgemäß sind die Merkmale nach Patentanspruch 1 vorgesehen. Bei der erfindungsgemäßen Ausbildung ist zweckmäßig zusätzlich zur Anschlußverbindung, welche gegenüber der Leiteranordnung und dem Träger eine wesentlich kleinere Flächenerstreckung hat, eine Lagesicherung vorgesehen, welche die Lage des zweiten Anschlußteiles, des daran bzw. an die Anschlußflächen anschließenden Längsabschnittes des Anschlußleiters und/oder eine den Anschlußleiter schlauch- bzw. mantelförmig umgebende Isolierung gegenüber dem Träger kraftbzw. formschlüssig sichert und/oder mindestens einen dieser Bereiche bzw. die erste Anschlußfläche, nicht jedoch die Leiteranordnung, auf der vom Träger abgekehrten Seite im wesentlichen abdeckt oder dicht umschließt.

Auch diese Lagesicherung kann nach Art einer Mikrofügung bzw. Haftverbindung ausgebildet sein, besteht im wesentlichen durchgehend aus einem elektrisch isolierenden Werkstoff und ist vorzugsweise ausschließlich durch Haftung an einem der genannten Bereiche bzw. an der zugehörigen Oberfläche des Trägers befestigt. Die Lagesicherung kann auch im Abstand vom zweiten Anschlußteil zwischen die Einzeldrähte des Anschlußleiters eingreifen bzw. zwischen diesem sowie der Isolierung und der zugehörigen Oberfläche des Trägers eine Verbindungsschicht bilden, deren Dicke kleiner als die des Trägers bzw. der Durchmesser des Anschlußleiters ist. Dadurch kann der Anschlußleiter im Anschluß an die Mikrofügung im wesentlichen lückenlos und von außen unzugänglich in eine Isoliermasse eingebettet sein. Durch die Lagesicherung kann der Anschlußleiter im Anschluß an die Anschlußverbindung weder vom Träger abgehoben noch gegenüber diesem in seiner Längsrichtung durch Zugbelastung lageverändert werden.

Die Mikrofügung kann auch eine Verbindung durch Schweißen, Löten, Kleben oder dergleichen einschließen. Bevorzugt ist eine Schweißverbindung dergestalt vorgesehen, daß eine die Anschlußflächen einschließende Verbindungsschicht durch Festkörperdiffusion eine intermetallische Phase aus den Werkstoffen beider Anschlußteile bildet, wobei die Konzentration des Materials des jeweiligen Anschlußteiles zu diesem hin zunimmt. Diese Verbindung kann durch Druck quer zu den Anschlußflächen, Relativbewegungen zwischen den Anschlußflächen und/oder Zuführung von Wärme hergestellt werden, nämlich z.B. durch Ultraschall-, Thermokompressions- und/oder Thermosonic-Schweißen. Bei Schweißen mit Ultraschall liegt der Schwingungsvektor parallel zu den Anschlußflächen und dadurch werden die Relativbewegungen zwischen diesen erzeugt. Beim Schweißen durch Thermokompression wird die Verbindung unter Einwirkung von Druck und Wärme bei gleichzeitiger plastischer Verformung des Anschlußteiles des Anschlußleiters hergestellt. Beim Theromosonic-Schweißen wird die Verbindung unter Einwirkung von Druck, Wärme und Ultraschall-Energie erzeugt, wobei hier der Schwingungsvektor quer zu den Anschlußflächen liegt.

Mit diesen Preßschweißverfahren wird die Verbindung durch Bonden hergestellt, da die Metallgitter der beiden Anschlußflächen auf Gitter-Abstand angenähert werden, wobei mindestens eine der Anschlußflächen plastisch verformt und hierzu deren Duktilität durch Erwärmung und/oder Ultraschall-Energie erhöht wird, da diese ein Erweichen und besseres Fließen des Werkstoffes nach Art einer Kaltverformung bewirken. Evtl. vorhandene Oxydschichten sind zu entfernen um die Kaltverschweißung zu verbessern. Die durch Metallisierung gebildete Leiterbahn bzw. der zugehörige Anschlußteil können auch durch Walzplattierung, galvanischen Auftrag oder dergleichen am Träger angebracht werden.

Die Schaltung kann einen elektrischen Widerstand, z.B. in Form eines Sensors, einer Steuerbeheizung oder dergleichen enthalten und ist zweckmäßig teilweise oder vollständig durch eine Dickschicht-Leiterbahn gebildet. Die Leiterbahn wird mit einer, Bindemittel enthaltenden Paste als Siebdruck auf eine elektrisch isolierende Oberfläche des Trägers aufgebracht und dann durch Einbrennen bzw. Sintern als dünne Schicht von weniger als einem zehntel oder einem hundertstel Milimeter Dicke gehärtet. Enden der Leiterbahn bilden gegenüber dieser verbreiterte bzw. im Leiterquerschnitt mehr als zehnfach vergrößerte Anschlußteile, die ebenfalls als Dickschicht ausgeführt zur Leiterbahn gehören und wie diese im Abstand von einer bis allen Außenkanten des Trägers innerhalb von dessen zugehöriger Schaltungs-Oberfläche liegen können.

Erfindungsgemäß sind Mittel vorgesehen, um die Arbeits- bzw. die Betriebstemperatur der Anschlußverbindung auf mindestens 300, 350 oder 450° C ohne deren Anfälligkeit gegen Beschädigung zu erhöhen. Zweckmäßig ist die Anschlußverbindung dabei gegen Temperaturzyklen RT bis mindestens 320° C standfest. Dadurch kann die Schaltung z.B. im Heizbereich eines Wärmegerätes, wie einer Kochstellenbeheizung angeordnet und beispielsweise im Falle eines Induktionsheizers dessen Heizenergie ausgesetzt werden, so daß sie als Sensor für diese Beheizung geeignet ist.

Die zweite Anschlußfläche des Anschlußleiters bzw. die intermetallische Phase ist vorteilhaft kupferhaltig, wobei der zweite Anschlußteil teilweise oder vollständig aus Kupfer besteht und gegebenenfalls an seiner Oberfläche versilbert ist. Die Anschlußfläche der Leiteranordnung enthält zweckmäßig Silber bzw. Palladium, wobei sie vollständig aus Silber oder einer Silber-Palladium-Legierung bestehen kann. Dadurch enthält die intermetallische Phase auch Silber.

Der zweite Anschlußteil bildet zweckmäßig ein flaches Band bzw. eine Kette mit gegenüber dem ersten Anschlußteil vielfach größerer Dicke, die mindestens zwanzig- oder vierzigfach größer als die Dicke des ersten Anschlußteiles sein kann und zweckmäßig unterhalb einem Millimeter und oberhalb ein- oder zwei Zehntel Millimeter liegt. Zweckmäßig weist dieser Anschlußteil, insbesondere in seiner Längsrichtung, abwechselnd unterschiedliche Dicken z.B. dadurch auf, daß seine von der ersten Anschlußfläche abgekehrte flache Oberfläche im Querschnitt bzw. über seine gesamte Breite durchgehend durch die plastische Verformung bei der Verbindung gewellt ist. In den Wellentälern ergeben sich dadurch erhöhte Druckbelastungen, so daß hier die Schweißverbindung besonders fest ist und mehrere solche im Abstand voneinander liegende Bereiche benachbart zueinander gebildet sind.

Der zweite Anschlußteil könnte zwar im Querschnitt durchgehend einteilig sein, besteht jedoch zweckmäßig aus mindestens zwei oder fünf gesonderten Teilen, die gleiche Leiterquerschnitte haben können. Diese Teile können zum Beispiel durch die etwa sieben Einzeldrähte einer Litze gebildet und miteinander verdrillt sein und/oder parallel nebeneinander liegen, wobei die Summe der Querschnitte der Einzeldrähte den Leiterquerschnitt von z.B. weniger als 5 oder 3 mm² des Anschlußteiles und des Anschlußleiters bildet.

Die gesonderten Teilstränge des Anschlußleiters berühren einander mit ihren Umfangsflächen über die Länge des Anschlußteils bzw. der zweiten Anschlußfläche durchgehend und sind im Querschnitt durch die plastische Verformung so aneinander angeformt, daß sie nicht nur annähernd lückenlos aneinander anliegen, sondern mit ihren Oberflächen auch im Quer-Abstand zur Anschlußverbindung durch die genannte Mikrofügung bzw. Verschweißung im wesentlichen durchgehend miteinander leitend verbunden sind. Die maximale Dicke des zweiten Anschlußteiles kann dadurch im Bereich des Durchmessers der Einzeldrähte oder nur geringfügig, nämlich höchstens um das zwei-, drei- oder vierfache darüber liegen.

Der Träger kann teilweise oder vollständig durch ein Keramiksubstrat gebildet sein. Er kann aber auch aus Metall bestehen und an der Schaltungs-Oberfläche mit einer Isolierschicht versehen sein, auf welcher die Schaltung angeordnet ist. Die erfindungsgemäße Ausbildung ist insbesondere für sehr kleine Schaltungen geeignet, deren Träger eine Flächenausdehnung von weniger als 50, 20 oder 10 cm² und eine Dicke von weniger als 5, 3 oder 1 mm aufweist. Die Anschlußverbindung kann Stromleistungen von mehr als 1 Ampere übertragen und bis etwa 500°C Betriebstemperatur eingesetzt werden.

Diese und weitere Merkmale gehen außer aus den Ansprüchen auch aus der Beschreibung und den Zeichnungen hervor, wobei die einzelnen Merkmale jeweils sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Ein Ausführungsbeispiel der Erfindung ist in den Zeichnungen dargestellt und wird im foglenden näher erläutert. In den Zeichnungen zeigen:
- Fig. 1: eine erfindungsgemäße Schaltung in Ansicht und wesentlich vergrößerter Darstellung;
- Fig. 2: einen Ausschnitt der Schaltung im Querschnitt nach der Linie II, und
- Fig. 3: einen Ausschnitt der Schaltung im Querschnitt nach der Linie III und in nochmals weiter vergrößerter Darstellung.

Die Baueinheit bzw. Schaltung 1 weist einen plattenförmigen, durchgehend einteiligen und gegebenenfalls mehrschichtigen sowie glasartig biegefesten Träger 2 als Substratkörper auf, welcher alle übrigen Bauteile bzw. Elemente der Schaltung 1 trägt. Der aus einer größeren Keramikplatte geschnittene, langgestreckt rechteckige Träger 2 aus Hartkeramik hat durchgehend geradlinige äußerste Kantenflächen, nämlich zwei parallele Längskanten 3 und zwei sie quer bzw. rechtwinklig verbindende Querkanten 4, 5. Die von diesen Kanten 3 bis 5 begrenzten äußersten Plattenflächen 6, 7 sind jeweils durchgehend eben und wie der Träger 2 frei von Durchbrechungen.

Auf nur einer Fläche 6 ist eine langgestreckte elektrische Leiteranordnung 8 parallel zur Längsrichtung des Trägers 2 und mit einem Abstand von jeder Kante 3 bis 5 vorgesehen, der mindestens so breit wie die Breite der Leiteranordnung 8 oder demgegenüber breiter ist. Die Leiteranordnung 8 besteht ausschließlich aus einer durch Pastenbeschichtung der Oberfläche 6 gebildeten Metallisierung und bildet eine weniger als einen oder einen halben Milimeter breite Leiterbahn, deren Längsabschnitte parallel zur Längsrichtung der Anordnung 8 mit Zwischenabständen vorgesehen sind, die höchstens doppelt oder dreifach so groß wie die Breite der Längsabschnitte sind. Die Längsabschnitte sind an ihren Enden abwechselnd mäanderförmig über Querabschnitte der Leitbahn 9 miteinander verbunden. Die seitlich äußersten Längsabschnitte schließen am selben Ende der Anordnung 8 an erste Anschlußteile 11 an, die wie die Leiterbahn 9 ausgebildet und an der Fläche 6 befestigt sind sowie gleiche Schichtdicke wie die Leiterbahn 9 haben. Die parallel zur Anordnung 8 langgestreckten Anschlußteile 11 sind jeweils mindestens zehnfach breiter als die Leiterbahn 9, haben etwa gleiche Abstände wie diese von der jeweils benachbarten Kante 3 und einen gegenüber ihrer Breite mehrfach kleineren Zwischenabstand. Die von der Fläche 6 abgekehrte, durchgehend ebene Oberfläche jedes Anschlußteiles 11 bildet eine erste Anschlußfläche 12.

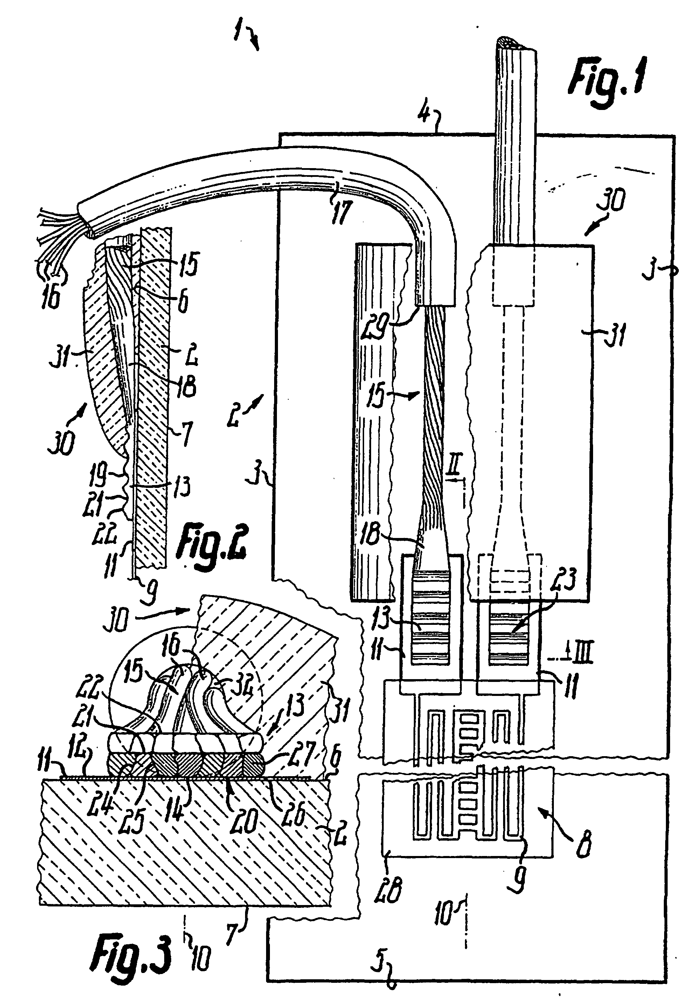

An jeder Anschlußfläche 12 ist ein zweiter Anschlußteil 13 in Form eines band- oder plattenförmigen Fußes mit einer ebenfalls durchgehend ebenen, zweiten Anschlußfläche 14 nur durch Zerstörung lösbar und haftend befestigt, welcher durch das Ende eines einteilig mit ihm ausgebildeten Anschlußleiters 15 gebildet ist. Der Leiter 15 ist eine Drahtlitze aus sieben Einzeldrähten 16, welche im Abstand vom Fuß 13 von einer achssymetrischen elektrischen Isolierung vormontiert umgeben ist, wobei durch Trennen eines Längsabschnittes diese Isolierung, der Fuß 13 und ein anschließender Abschnitt des Leiters 15 nur in dem Bereich freigelegt sind, in dem sie in Ansicht gemäß Fig. 1 innerhalb der Kanten 3 bis 5 liegen. Die Isolierung 17 geht über die zugehörige Länge sowie den Umfang des Leiters 15 ununterbrochen einteilig durch. Der Leiter 15 ist außerhalb sowie im Bereich der Isolierung 17 bzw. gemeinsam mit dieser so biegeweich, daß er manuell in allen Richtungen gekrümmt werden kann und dann eigensteif die Krümmung beibehält.

Der Abstand der Anordnung 8 von der den Anschlußteilen 11 benachbarten Kante 4 ist größer, beispielsweise mindestens zwei- oder dreifach größer als der Abstand des anderen Endes von der zugehörigen Kante 5. Dadurch ist zwischen der Anordnung 8 und der Kante 4 ein auch von den Kanten 3 begrenztes, von Leiterodnungen freies Feld der Fläche 6 gebildet, in welchem die Leiter 15 gegenüber dem Träger 2 ein- oder mehrfach gesichert werden können. Im wesentlichen alle beschriebenen Anordnungen und Ausbildungen liegen symetrisch zu einer zwischen den Kanten 3 liegenden Längs-Mittelebenen 10 des Trägers 2 bzw. der Schaltung 1. Der Leiter 15 kann allerdings so abgewinkelt werden, daß er in Ansicht auf die Fläche 6 die Kante 4 nicht kreuzt, sondern nur eine der Kanten 3.

Beide Füße 13 sind gleich ausgebildet. Der in Ansicht langgestreckt rechteckige Fuß 13 geht über eine Ferse 18 in den übrigen, zylindrisch begrenzten Leiter 15 über. Die Ferse 18 ist in Ansicht gemäß Fig. 1 von der Breite des Fußes 13 kontinuierlich auf den Durchmesser des Leiters 15 verjüngt und in Seitenansicht gemäß Fig. 2 von der Dicke des Fußes 13 kontinuierlich auf diesen Durchmesser erweitert, so daß sich von dem gegenüber dem Durchmesser des Leiters 15 breiteren und dünneren Flachquerschnitt des Fußes 13 stetige Übergänge in den Rundquerschnitt des Leiters 15 auf einer Länge ergeben, die in der Größenordnung der Länge des Fußes 13 liegt. Die vom Anschlußteil 11 abgekehrte Oberfläche 19 des Fußes 13 ist durch Vertiefungen bzw. Erhöhungen profiliert, während die Oberflächen der Ferse 18 von solchen Profilierungen frei bzw. glattflächig sein können. Die Verjüngung bzw. Erweiterung der Ferse 18 ist spitzwinklig.

Die Anschlußfläche 14 des Fußes 13 ist schmaler und kürzer als die Anschlußfläche 12 und liegt mit Abstand von beiden parallelen Längs- bzw. beiden dazu rechtwinkligen Querkanten des Anschlußteiles 11. Die miteinander kontaktierten Anschlußflächen 12, 14 sind mechanisch lagegesichert durch eine Anschlußverbindung 20, nämlich eine Preßschweißung, miteinander verbunden, die sich ununterbrochen über die Anschlußfläche 14 erstreckt. Die Anschlußfläche 12 besteht aus Silber oder Silber-Palladium und die Anschlußfläche 14 aus einer ununterbrochen durchgehenden Silberbeschichtung jedes der Einzeldrähte 16, die jeweils aus Kupfer bestehen und vollständig von der mikrodünnen Silberschicht ummantelt sind. Für die Schweißung wird das Ende des Leiters 15 mit noch rundem Querschnitt in einer Vertiefung eines Werkzeuges aufgenommen, welches gemeinsam mit der Fläche 12 die Negativform des Fußes 13 darstellt. Mit diesem Werkzeug wird das Leiterende quer zu seiner Längsrichtung gegen die Fläche 12 gepreßt und mittels Ultraschall-Schweißen sowie Thermokompressions-Schweißen mit der Fläche 12 verbunden, wobei gleichzeitig der Preßdruck eine plastische Verformung des Rundquerschnittes des Leiters 15 bewirkt und diesen in den flachen Querschnitt des Fußes 13 sowie den der Ferse 18 überführt.

Hierbei wird auch jeder der Einzeldrähte 16 aus seinem anfänglich kreisrunden Querschnitt in einen davon abweichenden Querschnitt plastisch verformt, insbesondere derart, daß aneinanderschließende Umfangs- bzw. Oberflächen 24 benachbarter Drähte 16 über die Länge des Fußes 13 komplementär aneinandergeformt, radial entsprechend stark gegeneinander gepreßt und großflächig durch Mikrofügungen 25 über die Länge des Fußes 13 bzw. der Fläche 14 miteinander verbunden sind. Durch die Ultraschallenergie und die Reibung zwischen den Flächen 12, 14 können dabei benachbart aneinander liegende Drähte 16 parallel und/oder quer zu ihrer Längerichtung bzw. parallel und/oder quer zu den Flächen 12, 14 gegeneinander bewegt werden, so daß durch die Reibung der Flächen 24 aneinander die Kaltverschweißungen 25 bewirkt werden. Alle Drähte 16 oder die Mehrzahl davon können über die gesamte Länge des Fußes 13 oder Teilabschnitte davon unmmittelbar zugehörige Längsabschnitte der Fläche 14 bilden, so daß z.B. alle Drähte 16 im Querschnitt gemäß Fig. 3 in einer einzigen Ebene liegen und von der Fläche 14 zur Fläche 19 durchgehen.

Das Preß- bzw. Schweißwerkzeug weist eine der Profilierungen der Fläche 19 entsprechend profilierte Preßfläche auf. Durch die Profilierung sind abwechselnd dünnere und dickere Abschnitte des Fußes 13 gebildet, welche zweckmäßig ausschließlich in dessen Längsrichtung hintereinander liegen und über seine Breite durchgehen. Im Bereich der dünneren Zonen 21 ergibt sich eine größere Preßkraft zwischen den Flächen 12, 14 und im Bereich der dickeren Zonen 22 eine demgegenüber geringere Preßkraft, die jedoch in ihrem Bereich ebenfalls zu einer Verschweißung führt. Die Profilierung kann in einfacher Weise als Wellung 23 ausgeführt sein, wobei der Abstand zwischen zwei benachbarten gleichen Zonen 21 bzw. 22 mehrfach kleiner als die Breite des Fußes 13 und mehrfach größer als dessen kleinste oder größte Dicke ist.

An die letzte Zone 21 bzw. 22 schließt unmittelbar und noch im Bereich der Fläche 12 die Ferse 18 an, welche an der Fläche 12 nicht befestigt ist, sondern von dieser und der Fläche 6 gemeinsam mit dem anschließenden Längsabschnitt des Leiters 15 durch Biegung abgehoben werden kann. Die Ferse 18 wird ebenfalls durch den Preßdruck beim Schweißen in die beschriebene Form gebracht und über einen an den Fuß 13 anschließenden Teil ihrer Länge können die Drähte 16 in der beschriebenen Weise ebenfalls miteinander verschweißen. Daran anschließend und im Bereich des übrigen Leiters 15 bleiben die Drähte unverschweißt und gegeneinander beweglich.

Der gesamt Leiterquerschnitt 27 des Fußes 13, der gleich demjenigen der Ferse 18 und des restlichen Leiters 15 ist, beträgt hier 0,22 mm² und ist gegenüber dem auf die Breite der Fläche 14 begrenzten Leiterquerschnitt des Anschlußteiles 11 mindestens zehn- oder zwanzigfach größer. Die Querschnittsbreite des Fußes 13 ist mindestens zwei- oder vierfach größer als dessen kleinste oder größte Dicke, wobei sich die Zonen 21, 22 quer zur Längsrichtung der Drähte 16 erstrecken. Gegenüber der Leiterbahn 9 sind die Leitungsquerschnitte 27 mehrere hundertfach größer.

Die Leiteranordnung 8 bzw. die gesamte Leiterbahn 9 und nur an diese angrenzende Teilabschnitte der Anschlußteile 11, nicht jedoch die von den Füßen 13 bzw. den Flächen 14 belegten Bereiche sind mit einer dünnen transparenten Schicht 28 aus einem transparenten, elektrisch isolierenden Lack oder dergleichen abgedeckt, welche in Ansicht gemäß Fig. 1 allseits über die Leiteranordnung 8 vorstehend und zwischen den Abschnitten der Leiterbahn ganzflächig haftend mit der Oberfläche 6 sowie mit der von dieser abgekehrten Oberfläche der gesamten Leiterbahn 9 verbunden ist. Die Schicht 28 hat von allen Kanten 3 bis 5 Abstand.

Jede Verbindung 20, jede Ferse 18, jeder an diese anschließende Abschnitt des Leiters 15 und das zugehörige Ende der Isolierung 17 sind für sich zusätzlich mit einer gemeinsamen Sicherung 30 unmittelbar gegenüber dem Träger 2 bzw. der Fläche 6 gesichert, wobei diese Sicherung 30 ausschließlich in die Fläche 6 und nicht in die Flächen 3 bis 5 und 7 eingreift. Eine gemeinsame Sicherung 30 bzw. ein gemeinsames oder einteiliges Sicherungsglied kann für beide benachbarten Anschlüsse oder Leiter 15 vorgesehen sein, die im Abstand parallel zueinander von den Füßen 13 weggeführt sind. Die Sicherung 30 ist zweckmäßig haftend mit den Flächen 6, 12, 19 verbunden und zwar sowohl an den voneinander abgekehrten Seiten der Elemente 11, 13, 18, 15, 17, als auch zwischen diesen, wobei diese Verbindung auch zwischen den Oberflächen 12, 6 und den diesen zugekehrten Seiten der Elemente 18, 15, 17 durchgehen kann.

Die Sicherung 30 bettet dadurch den Leiter 15 und das Ende der Isolierung 17 sowie einen Teil der Ferse 18 über den Umfang vollständig ein und schließt auch an die Seitenkanten des Fußes 13 sowie an die Endfläche 29 der Isolierung 17 an, so daß diese gegen Abziehen vom Leiter 15 gesichert ist. Von der einzigen leitenden Verbindung 20 stehen die Ferse 18 und der Leiter 15 innerhalb der Sicherung 30 und bis zu deren der Kante 4 zugekehrten Ende geradlinig sowie parallel zur Fläche 6 ohne weitere metallische Verbindung mit dieser ab.

Die Sicherung 30 besteht zweckmäßig durchgehend aus einem Isolierwerkstoff, insbesondere Hartkeramik, die als plastische Vergußmasse bzw. Kleber unter Pressung und Formung auf die genannten Flächen aufgebracht wird und dann aushärtet. Das freie Ende jedes Fußes 13 steht dann aus der Sicherung 30 vor, so daß der größte Teil der Fläche 19 als Kupferoberfläche frei liegt, weil durch die Preßschweißung die Silberbeschichtung abgetragen worden ist. Die Vergußmasse 31 kann vom Umfang des Leiters 15 her auch in die Längslücken 32 zwischen den Drähten 16 eindringen, diese unmittelbar gegeneinander sichern und so die Drähte 16 und deren Übergang in den Fuß 13 bzw. die Ferse 18 gegen Zugbelastung sichern.

Durch die beschriebene Ausbildung wird die Schaltung 1 bzw. der Träger 2 thermisch sehr gleichmäßig belastet, wobei die Sicherung 30 über die genannten Flächen thermisch sehr großflächig und eng angekoppelt ist. Durch Schließen des Stromkreises über die freien Enden der Leiter 15 wird die Leiteranordnung 8 wirksam. Die Schaltung 1 eignet sich insbesondere für Pt-Sensoren wie Temperaturfühler an Kochstellen, deren Beheizung durch Induktion auf das Kochgefäß übertragen wird. Die Länge des Trägers 2 ist zweckmäßig mindestens zwei- oder dreifach größer als seine Breite und der entsprechende Faktor des Feldes der Leiterordnung 8 ist demgegenüber mit mindestens fünf bzw. sieben größer. Die Länge dieses Feldes entspricht nur etwa der Hälfte des Trägers 2 und gegenüber beiden Längen ist die Länge der langgestreckten Sicherung 30 wesentlich kleiner. Die Schaltung kann, z.B. als Temperaturbegrenzer bzw. Überhitzungsschutz, mit dem Leiterfeld frei in einen Innenraum eine Heizeinheit vorstehend angeordnet und nur seitlich der Leiter 15 bzw. der Sicherung 30 gehaltert sein, z.B. durch Umgreifen der Kanten 3, 4 mit federnden Klammern, einem ausgehärteten plastischen Kleber, einer Vergußmasse oder dergleichen.

Die erläuterten Eigenschaften können genau wie beschrieben oder nur etwa bzw. im wesentlichen wie beschrieben und auch stark davon abweichend vorgesehen sein.

## Patentansprüche

1. Elektrische Schaltung mit einem Träger (2), einer wenigstens teilweise durch eine Leiterschicht od.dgl. gebildeten Leiteranordnung (8), wie einer Widerstandsanordnung und mit wenigstens einer Anschlußverbindung (20), die einen mit der Leiteranordnung (8) über eine Mikrofügung verbundenen, eine erste Anschlußfläche (12) bildenden Anschlußteil (11) des Trägers (2) und einen zweiten, eine zweite Anschlußfläche (14) bildenden Anschlußteil (13) einer Anschlußleitung (15) enthält, wobei eine der beiden durch die Leiteranordnung (8) und den ersten Anschlußteil (11) gebildeten Anordnungen einen maximalen sowie einen minimalen ersten Leiterquerschnitt (26) und der zweite Anschlußteil (13) einen zweiten Leiterquerschnitt (27) definieren und wobei der zweite Leiterquerschnitt (27) vielfach größer als der erste Leiterquerschnitt (26) oder mindestens einer der Anschlußteile (11, 13) kupferhaltig sein kann, **dadurch gekennzeichnet, dass** zusätzlich zur Anschlussverbindung (20) eine Lagesicherung (30) für die Anschlussleitung (15) an dem Träger (2) angeordnet ist.

2. Schaltung nach Anspruch 1, **dadurch gekennzeichnet, daß** der zweite Anschlußteil (13) Flachquerschnitte aufweist, daß insbesondere der Anschlußteil (13) aus mehreren benachbart aneinanderschließenden und mit ihren Oberflächen (24) unmittelbar durch Mikrofügung (25) miteinander leitend fest verbundenen Einzelsträngen (16) besteht und daß vorzugsweise die Einzelstränge (16) im Querschnitt im wesentlichen parallel zur Anschlußfläche (12, 14) nebeneinander liegend durch plastische Verformung flachgedrückt aneinander komplementär angeformt sind.

3. Schaltung nach Anspruch 1 oder 2, **dadurch gekennzeichnet, daß** der zweite Anschlußteil (13) im wesentlichen aus Kupfer besteht, das insbesondere die Anschlußverbindung (20) silberhaltig ist und daß vorzugsweise die Mikrofügung durch eine Preßschweißung, wie eine Ultraschall-Schweißung, eine Thermokompressions-Schweißung, eine Thermosonic-Schweißung oder dergleichen gebildet ist.

4. Schaltung nach einem der vorhergehenden Ansprüche, **dadurch gekennzeichnet, daß** der zweite Leiterquerschnitt (27) mindestens zweihundertfach größer als der erste Leiterquerschnitt (26) der Leiteranordnung (8) ist, daß insbesondere der zweite Anschlußteil (13) auf abwechselnd unterschiedliche Dicken (21, 22) verpreßt ist und das vorzugsweise der erste Anschlußteil (11) und/oder die Leiterschicht (9) auf dem Träger als Verbundschicht aus einer gesinterten Paste angeordnet ist.

5. Schaltung nach einem der vorhergehenden Ansprüche, **dadurch gekennzeichnet, daß** der Träger (2) an einer elektrisch isolierenden Trägeroberfläche (6) ein Leiterfeld mit der Leiteranordnung (8) und zwei benachbarten ersten Anschlußteilen (11) bildet, wobei die Trägeroberfläche (6) mindestens dreifach größer als das Leiterfeld ist, daß insbesondere das Leiterfeld im wesentlichen symmetrisch zu einer Mittelebene (10) der Trägeroberfläche (6) angeordnet ist und daß vorzugsweise das Leiterferdlanggestreckt parallel zu einer Längsrichtung der Trägeroberfläche (6) ausgebildet ist, die an einem die Anschlußteile (11) aufweisende Ende des Leiterfeldes über dieses um mindestens das doppelte der Breite des Leiterfeldes vorsteht.

6. Schaltung nach einem der vorhergehenden Ansprüche, **dadurch gekennzeichnet, daß** der Träger (2) durch eine Platte von im wesentlichen durchgehend konstanter Dicke gebildet ist, daß insbesondere die Flächenausdehnung des Trägers (2) kleiner als 30 cm² ist und daß vorzugsweise der zweite Leiterquerschnitt (27) größer als 0,2 mm² ist.

7. Schaltung nach einem der vorhergehenden Ansprüche, **dadurch gekennzeichnet, daß** die Anschlußleitung (15) wenigstens auf einem Teil ihrer Länge von einer elektrischen Isolierhülle (17) umgeben ist, das insbesondere die Isolierhülle (17) den Träger (2) überdeckt und daß vorzugsweise die Isolierhülle (17) gegenüber der zweiten Anschlußfläche (14) einen Längsabstand hat, der mehrfach größer als die Längserstreckung der Mikrofügung ist.

8. Schaltung nach einem der vorhergehenden Ansprüche, **dadurch gekennzeichnet, daß** die Lagesicherung (30) eine im Abstand von der Mikrofügung liegende form- und kraftschlüssige Abheb- sowie Zugsicherung für den zweiten Anschlußteil (13) enthält, daß insbesondere die Lagesicherung (30) im wesentlichen unmittelbar in Eingriffsflächen mindestens eines Anschlußteiles (11, 13), des Anschlußleiters (15), von dessen Isolierung (17) und/oder der zugehörigen Trägeroberfläche (6) eingreift und daß vorzugsweise die Lagesicherung (30) im wesentlichen durchgehend in zwei gesonderte Anschlußleiter (15) eingreift.

9. Schaltung nach einem der vorhergehenden Ansprüche, **dadurch gekennzeichnet, daß** die Lagesicherung (30) an Eingriffsflächen plastisch angeformt ist, daß insbesondere die Lagesicherung (30) eine starr erhärtete Klebe- bzw. Vergußmasse (31) enthält und daß vorzugsweise die Lagesicherung eine Keramikmasse enthält.

10. Schaltung nach einem der vorhergehenden Ansprüche, **dadurch gekennzeichnet, daß** die Anschlußverbindung (20) zur Übertragung einer Stromleistung von mindestens einem halten Ampere ausgebildet ist, daß insbesondere die Anschlußverbindung (20) für eine Temperaturbelastung über 250°C ausgebildet ist und daß vorzugsweise die Anschlußverbindung (20), der Träger (2) die Leiteranordnung (8) und mindestens ein Anschlußleiter (15) eine vormontierte flächige Baueinheit (1) bilden.

## Claims

1. An electrical circuit, including a substrate (2), a conductor array (8) formed at least in part by a conducting layer or the like, such as a resistor array, and at least one contact (20), comprising a contact part (11) of said substrate (2) connected to said conductor array (8) by a microbond, forming a first contact area (12) and a second contact part (13) of a connecting lead (15) forming a second contact area (14), one of said two arrays formed by said conductor array (8) or said first contact part (11) defining a maximum and a minimum first conductive cross-section (26) and said second contact part (13) defining a second conductive cross-section (27) and said second conductive cross-section (27) may being many times larger than said first conductive cross-section (26) or at least one of said contact parts (11, 13) may contain copper **characterized in that** in addition to the contact (20) a positional seal (30) for said connecting lead (15) is arranged on said substrate (2).

2. The circuit as set forth in claim 1, wherein said second contact part (13) comprises flat cross-sections, in particular said contact part (13) consisting of several juxtaposed individual wires (16) firmly connected conductingly to each other by their surfaces (24) directly due to microbonding (25) and preferably said individual wires (16) being formed compressed flat on each other complementary in cross-section substantially parallel to said contact area (12, 14) located alongside each other by plastic deformation.

3. The circuit as set forth in claim 1 or 2, wherein said second contact part (13) consists substantially of copper, said contact (20) in particular containing silver and preferably said microbond being formed by a compression bond, such as an ultrasonic bond, a thermocompression bond, a thermosonic bond or the like.

4. The circuit as set forth in any of the preceding claims, wherein said second conductive cross-section (27) is at least two hundred times larger than said first conductive cross-section (26) of said conductor array (8), particularly said second contact part (13) being compressed to alternately differing thicknesses (21, 22) and preferably said first contact part (11) and/or said conducting layer (9) being arranged on said substrate as a compound layer of a sintered paste.

5. The circuit as set forth in any of the preceding claims, wherein said substrate (2) forms on an electrical insulating substrate surface (6) a conductor field with a conductor array (8) and two adjacent first contact parts (11), said substrate surface (6) being at least three times larger than said conductor field, in particular said conductor field being arranged substantially symmetrical to a center plane (10) of said substrate surface (6) and preferably said conductor field being configured elongated parallel to a longitudinal direction of said substrate surface (6) which at one end of said conductor field comprising said contact parts (11) extends beyond the latter by at least twice the width of said conductor field.

6. The circuit as set forth in any of the preceding claims, wherein said substrate (2) is formed by a plate of substantially constant thickness throughout, in particular the area extent of said substrate (2) being smaller than 30 cm² and preferably said second conductive cross-section (27) being greater than 0.2 mm².

7. The circuit as set forth in any of the preceding claims, wherein said connecting lead (15) is surrounded at least over part of its length by an electrical insulating sleeve (17), in particular said insulating sleeve (17) covering said substrate (2) and preferably said insulating sleeve (17) having a longitudinal spacing with respect to said second contact area (14) which is many times greater than the longitudinal extent of said microbond.

8. The circuit as set forth in any of the preceding claims, wherein said positional seal (30) contains a seal against lifting-off and pulling of said second contact part (13) by positive action located spaced away from said microbond, in particular said positional seal (30) engaging substantially directly engaging areas of at least one contact part (11, 13), of said connecting lead (15), the insulation (17) thereof and/or of the associated substrate surface (6) and preferably said positional seal (30) engaging two separate connecting leads (15) substantially throughout.

9. The circuit as set forth in any of the preceding claims, wherein said positional seal (30) is plastically formed on engagement areas, in particular said positional seal (30) containing a rigidly hardening bonding or potting compound (31) and preferably said positional seal containing a ceramic compound.

10. The circuit as set forth in any of the preceding claims, wherein said contact (20) is configured for the transmission of a current of at least half an Ampere, in particular said contact (20) bein configured for a temperature loading in excess of 250°C and preferably said contact (20), said substrate (2), said conductor array (8) and at least one connecting lead (15) forming a preassembled flat package (1).

## Revendications

1. Circuit électrique avec un support (2), une configuration de conducteurs (8) constituée au moins en partie par une couche conductrice ou similaires, telle qu'une configuration de résistances et avec au moins un raccordement de connexion (20), raccordement comprenant un élément de connexion (11) du support (2) raccordé avec la configuration de conducteurs (8) au moyen d'un microassemblage et formant une première surface de connexion (12), et un deuxième élément de connexion (13) d'un conducteur de connexion (15), raccordement formant une deuxième surface de connexion (14), où une des deux configurations, formées par la configuration de conducteurs (8) et par un premier élément de connexion (11), définit une première section de conducteur (26) maximale ainsi qu'une section (26) minimale et le deuxième élément de connexion (13) définit une deuxième section de conducteur (27) et où la deuxième section de conducteur (27) est de plusieurs fois plus grande que la première section de conducteur (26) ou au moins un des éléments de connexion (11, 13) est composé d'une matière cuivreuse, **caractérisé en ce que**, additionnellement au raccordement de connexion (20), un assurage de position (30) est disposé sur le support (2) pour le conducteur de connexion (15).

2. Circuit d'après la revendication 1, **caractérisé en ce que** le deuxième élément de connexion (13) présente des sections transversales plates, **en ce que** notamment l'élément de connexion (13) est composé de plusieurs brins individuels (16), qui se trouvent l'un à la suite de l'autre de manière limitrophe et qui sont raccordés de manière électriquement conductible et fixe par leurs surfaces (24) directement par microassemblage (25), et **en ce que** de préférence les brins individuels (16) épousent entr'eux, en section transversale, se trouvant l'un à côté de l'autre en substance parallèlement à la surface de connexion (12, 14), la forme de leurs corps de manière complémentaire, étant aplatis par déformation rémanente.

3. Circuit d'après la revendication 1 ou 2, **caractérisé en ce que** le deuxième élément de connexion (13) est composé essentiellement de cuivre, **en ce que** notamment le raccordement de connexion (20) est argentifère et **en ce que** de préférence le microassemblage est formé par un soudage avec pression, tel qu'un soudage par ultrasons, un soudage par thermo-compression, un soudage "thermosonic" ou similaires.

4. Circuit d'après une des revendications précédentes, **caractérisé en ce que** la deuxième section de conducteur (27) est au moins de deux cent fois plus grande que la première section de conducteur (26) de la configuration de conducteurs (8), **en ce que** notamment le deuxième élément de connexion (13) est comprimé à des épaisseurs (21, 22) alternativement différentes et **en ce que** de préférence le premier élément de connexion (11) et/ou la couche conductrice (9) est disposé sur le support en tant que couche composite en une pâte sintérisée.

5. Circuit d'après une des revendications précédentes, **caractérisé en ce que** le support (2) forme sur une surface de support (6) électriquement isolante une zone de conduction au moyen de la configuration de conducteurs (8) et deux premiers éléments de connexion (11) limitrophes, la surface de support (6) étant au moins trois fois plus grande que la zone de conduction, **en ce que** notamment la zone de conduction est disposée de manière essentiellement symétrique par rapport à un plan médian (10) de la surface de support (6) et **en ce que** de préférence la zone de conduction est réalisée de manière allongée parallèlement par rapport à une direction longitudinale de la surface de support (6), surface laquelle saille à une extrémité, présentant les éléments de connexion (11), de la zone de conduction au-delà de celle-ci d'une mesure correspondant au moins au double de la largeur de la zone de conduction.

6. Circuit d'après une des revendications précédentes, **caractérisé en ce que** le support (2) est constitué par une plaque présentant une épaisseur constante essentiellement de manière continue, **en ce que** notamment l'étendue superficielle du support (2) est inférieure à 30 cm² et **en ce que** de préférence la deuxième section de conducteur (27) est supérieure à 0,2 mm².

7. Circuit d'après une des revendications précédentes, **caractérisé en ce que** le conducteur de connexion (15) est entouré au moins sur une partie de sa longueur d'une gaine électriquement isolante (17), **en ce que** notamment la gaine isolante (17) se superpose au support (2) et **en ce que** de préférence le gaine isolante (17) présente par rapport à la deuxième surface de connexion (14) un écart longitudinal étant de plusieurs fois plus grand que l'étendue longitudinale du microassemblage.

8. Circuit d'après une des revendications précédentes, **caractérisé en ce que** l'assurage de position (30) comprend un assurage pour le deuxième élément de connexion (13), résistant au détachement ainsi qu'à la traction à engagement de forme et par adhérence situé à une certaine distance du microassemblage, **en ce que** notamment l'assurage de position (30) s'engage en substance directement dans des surfaces d'engagement au moins d'un élément de connexion (11, 13), d'un conducteur de connexion (15), de l'isolation (17) de celui-ci et/ou de la surface de support (6) correspondante et **en ce que** de préférence l'assurage de position (30) s'engage essentiellement de manière continue dans deux conducteurs de connexion (15) individuels.

9. Circuit d'après une des revendications précédentes, **caractérisé en ce que** l'assurage de position (30) est adapté de manière plastique à des surfaces d'engagement, **en ce que** notamment l'assurage de position (30) comprend une masse adhésive ou encore une masse de scellement (31) durcie de manière rigide et **en ce que** de préférence l'assurage de position comprend une masse céramique.

10. Circuit d'après une des revendications précédentes, **caractérisé en ce que** le raccordement de connexion (20) est réalisé pour la transmission d'une puissance par des courants au moins d'un demi ampère, **en ce que** notamment le raccordement de connexion (20) est réalisé pour une charge thermique dépassant les 250°C et **en ce que** de préférence le raccordement de connexion (20), le support (2), la configuration de conducteurs (8) et au moins un conducteur de connexion (15) forment un'unité constructive (1) prémontée et plate.
